# EUROPÄISCHE PATENTSCHRIFT

(11) **EP 4 241 097 B1**
(45) Veröffentlichungstag und Bekanntmachung des Hinweises auf die Patenterteilung: **02.12.2026**
(21) Anmeldenummer: 21823740.2
(22) Anmeldetag: 02.11.2021
(51) Int. Cl.: G01R 33/00, G01R 33/09, G01D 5/14, G01R 33/12, G01P 3/00

(54) **MAGNETISCHES SYSTEM ZUR ZÄHLUNG VON UMDREHUNGEN MIT ERHÖHTER MAGNETISCHER STÖRFELDFESTIGKEIT**
MAGNETIC SYSTEM FOR COUNTING REVOLUTIONS WITH AN ENHANCED MAGNETIC ROBUSTNESS
COMPTE-TOURS MAGNÉTIQUE AVEC UNE IMMUNITÉ AUX CHAMPS MAGNÉTIQUES AUGMENTÉE

(30) Priorität: 09.11.2020 DE 102020006987
(43) Veröffentlichungstag der Anmeldung: 13.09.2023
(73) Patentinhaber: Leibniz-Institut für Photonische Technologien e.V., 07745 Jena (DE); Horst Siedle GmbH & Co. KG., 78120 Furtwangen (DE)
(72) Erfinder: MATTEIS, Roland, 07743 Jena (DE)
(74) Vertreter: Pfeiffer, Rolf-Gerd
(86) Internationale Anmeldenummer: PCT/DE2021/000185
(87) Internationale Veröffentlichungsnummer: WO 2022/096050

(56) Entgegenhaltungen:
- WO-A1-2015/062573
- US-A1- 2010 232 072
- US-A1- 2020 217 907

## Beschreibung

Magnetische Sensoren können Eigenschaften eines magnetischen Feldes, wie z.B. deren Feldrichtung, detektieren. Ein Beispiel dafür ist ein Winkelsensor. Andere Arten von magnetischen Sensoren können bestimmen, wie oft sich ein Magnetfeld gedreht hat. Derartige Umdrehungszähler können beispielsweise durch einen GMR-Umdrehungszähler oder ein TMR-Umdrehungszähler gebildet sein, wie sie hinlänglich bekannter Stand der Technik sind. Solchen Sensoren beinhalten neben der Sensorfunktion in der Regel auch noch eine Speicherfunktion, das heißt, sie speichern ab, wie oft sich z. B. ein Permanentmagnet gedreht hat. Die Bestimmung der Anzahl von Umdrehungen geschieht nach dem Stand der Technik meist in Kombination mit einem Winkelsensor, der die genaue Richtung des Magnetfeldes bestimmt. So kann z.B. ein Messsystem, welches Winkel im Bereich z.B. von 0° bis 3.600° messen soll, aus einem Winkelsensor für die Bestimmung des Winkels entweder zwischen 0° und 180° (z.B. unter Verwendung eines AMR (Anisotroper Magnetowiderstands-Winkelsensor) oder zwischen 0° und 360° (unter Verwendung eines GMR- oder TMR-Winkelsensors oder eines Hall-Sensors oder eines anderen Winkelsensors) sowie aus einem Umdrehungszähler bestehen, der die Anzahl der Umdrehungen, im vorstehend genannten Beispiel von 0 bis 10, zu ermitteln gestattet. Beide Sensoren, das heißt der Winkelsensor und der Umdrehungszähler, sind als separat hergestellte Bauelemente ausgebildet und i.d.R. auf einer Leiterplatte nebeneinander angeordnet. Zusätzlich kann, wie erwähnt, ein Bauelement auf der Leiterplatte angeordnet sein, welches eine Auswerteelektronik beinhaltet. Dieses Bauelement kann eine Auswertung der Signale der beiden Sensoren, eine Bereitstellung von Versorgungsspannungen und auch eine Fehlerüberwachung vornehmen, wie z.B. in EP 3 387 387 B1 beschrieben. Oberhalb des Winkelsensors und Umdrehungszählers kann ein sich drehender Permanentmagnet angebracht sein, dessen Lateralausdehnung so festgelegt ist, dass das magnetische Streufeld unterhalb des Permanentmagneten die beiden genannten Sensoren hinreichend umfasst. Aber auch Linearanordnungen von Magneten, die z.B. als magnetisches Lineal arbeiten können, erzeugen beim Vorbeibewegen des Umdrehungszählers am magnetischen Lineal ein sich drehendes Magnetfeld, das mit Hilfe des Umdrehungszählers zur Realisierung einer Entfernungsmessung genutzt werden kann.

Die konkrete Anordnung der beiden Bauelemente (Winkelsensor und Umdrehungszähler), die vom Magnetfeld des Permanentmagneten gleichzeitig erfasst werden, ist durch die Eigenschaften der beiden Bauelemente beeinflusst. Dabei können die beiden Bauelemente z.B. nebeneinander auf einer Leiterplatte angeordnet werden. In dieser Geometrie erfahren sie den gleichen magnetischen Fluss B, der vom Permanentmagneten in der Ebene der Bauelemente erzeugt wird. Wie weiter unten begründet wird, weisen Anordnungen, bei denen der magnetische Fluss B am Ort des Umdrehungszählers kleiner ist als am Ort des Winkelsensors, Vorteile auf. Dies kann z.B. durch die Anordnung der beiden Bauelemente auf gegenüberliegenden Seiten einer einige Millimeter dicken Leiterplatine erreicht werden. Dadurch ist der Abstand des Permanentmagneten zu dem einen Bauelement um die Dicke der Leiterplatte vergrößert. Ist der Umdrehungszähler unterhalb der Leiterplatte angeordnet, ist der magnetische Fluss B am Ort des Umdrehungszählers, aufgrund des erhöhten Abstandes, kleiner als am Ort des Winkelsensors, der dem Feld B des Permanentmagneten näher liegend ausgesetzt ist. Eine weitere mögliche Anordnung, bei der das B-Feld am Ort des Umdrehungszählers kleiner ist als am Ort des Winkelsensors, könnte durch eine magnetische Abschirmschicht, die oberhalb des Umdrehungszählers angeordnet ist, erreicht werden. Dann könnten beide Sensoren auf der gleichen Seite der Leiterplatte angeordnet werden. Jedoch müssten Winkelsensor und Umdrehungszähler in einem solchen Fall einen größeren Abstand aufweisen, da sonst die Abschirmschicht das B-Feld auch am Ort des Winkelsensors in unerwünschter Weise reduziert.

Ein magnetischer Winkelsensor erreicht seine höchste Genauigkeit, wenn am Ort des Sensors hohe Werte des magnetischen Flusses B (≥ 100 mT), erzeugt durch genannten Permanentmagneten, vorliegen. Im Gegensatz dazu kann der Umdrehungszähler nur innerhalb eines magnetischen Fensters eine fehlerfreie Bestimmung der Anzahl von Umdrehungen liefern, das z.B. von 15 mT bis 30 mT reichen kann. Um den Winkel mit Hilfe des Winkelsensors z.B. auf besser 0,05° bestimmen zu können, ist ein Gebermagnetfeld von mindestens 100 mT erforderlich. Für den Umdrehungszähler hingegen darf dann das Gebermagnetfeld nur 23% dieses für den Winkelsensor optimalen Wertes, also 23 mT, betragen, um selbst idealerweise in der Mitte des B-Feldbereiches zu liegen, in dem der Umdrehungszähler fehlerfrei arbeitet.

Durch die unterschiedlichen Anforderungen an das einwirkende Magnetfeld auf die beiden erforderlichen Bauelemente ergeben sich für die vorstehend angedachten Anordnungen folgende Nachteile: Eine geometrisch benachbarte Anordnung der beiden Bauelemente auf einer Leiterplatte ohne Abschirmschicht erlaubt keine hochgenaue Bestimmung des Winkels, da der Umdrehungszähler das B-Feld am Ort des Winkelsensors typischerweise auf 23 mT festlegt, ansonsten könnte der Umdrehungszähler nicht in seinem vorgegebenen magnetischen Fenster arbeiten.

Eine Anordnung auf den beiden gegenüberliegenden Seiten einer dickeren Leiterplatte erlaubt, dass beide Sensoren in dem für sie idealen B-Feldbereich arbeiten. Jedoch muss die Dicke der Leiterplatte genau auf den Gebermagneten abgestimmt und z.B. beim Einsatz eines Permanentmagneten mit anderer Geometrie (z.B. für ein kleineres Messsystem) geändert werden. Eine Integration der beiden Sensoren in einem Chipgehäuse ist bei Vorgabe kleiner Baugrößen bei einer solchen Ausführung ausgeschlossen.

Die Verwendung einer magnetischen Abschirmschicht, bestehend aus einem homogenen weichmagnetischen Material, oberhalb des Umdrehungszähler würde zwar die Anordnung beider Sensoren auf der gleichen Leiterplattenseite und ihren jeweiligen Betrieb im optimalen B-Feldbereich ermöglichen, allerdings wäre dann eine Integration in einem gemeinsamen kleinen Chipgehäuse, aufgrund des hier erforderlichen Abstandes des Winkelsensors von der magnetischen Abschirmung, die oberhalb des Umdrehungszählers sitzt, nicht möglich, da eine solche Abschirmung zum einen den Umdrehungszähler lateral um ca. 60% überragen müsste und dann noch zusätzlich zum Winkelsensor lateral in der Größenordnung von mindestens 50% der lateralen Größe der magnetischen Abschirmung beabstandet sein müsste, damit seine Wirkung im Wesentlichen auf den Umdrehungszähler beschränkt bleibt und das B-Feld am Ort des Winkelsensors nur unwesentlich beeinflusst. Insbesondere den beiden Anordnungen ohne Verwendung einer Abschirmschicht ist es gemein, dass der Einfluss von außen auf das Sensorsystem einwirkenden magnetischen Störfeldern durch geeignete konstruktive Maßnahmen hinreichend stark reduziert werden muss. Solche Störfelder können z.B. entstehen, wenn in der Nähe des Sensorsystems große Ströme fließen, Andere Möglichkeiten des Auftretens von Störfeldern liegen in der Verwendung von Gegenständen mit Haftmagneten in der Nähe der Sensorsysteme, wie z.B. Beleuchtungslampen.

Für alle Anwendungen muss deshalb durch konstruktive Maßnahmen beim Design des Sensorsystems garantiert werden, dass im Betrieb des Sensorsystems das auf den Umdrehungszähler wirkende B-Feld immer innerhalb des spezifizierten vorgegebenen Bereiches des magnetischen Fensters liegt.

Dies sei an dem Beispiel illustriert, bei dem beispielsweise auf den Umdrehungszähler unter Realbedingungen ein B-Feld vom Gebermagneten im Bereich von 20 -25 mT wirkt. Dieser Bereich ist zum Beispiel bedingt durch die Temperaturabhängigkeit der Magnetisierung des Gebermagneten sowie durch mögliche unerwünschte mechanische Bewegungen des Permanentmagneten während des Betriebes, die den Abstand des Magneten von der Ebene, in der sich der Umdrehungszähler befindet, geringfügig ändern. Mit einem maximal erlaubten B-Feld von 30 mT bedeutet dies, dass die Konstruktion des Gesamtsystems so ausgelegt sein muss, dass ein auf das Gesamtsystem einwirkende Störmagnetfeld am Ort des Umdrehungssensors immer unterhalb 5 mT liegt. Wenn dies unter den Nutzungsbedingungen des Sensors nicht garantiert werden kann, muss dies mit zusätzlichen Abschirmmaßnahmen erreicht werden. Dies erfordert im Allgemeinen einen hohen konstruktiven und materiellen Aufwand und ist mit merklichen Zusatzkosten verbunden.

Die Verwendung einer weichmagnetischen Abschirmung am Ort des Umdrehungszählers für die Anpassung des B-Feld am Ort des Umdrehungszählers in sein magnetisches Fensters verbessert seine Störfeldfestigkeit. Dafür müsste die magnetische Abschirmung, ausgeführt z.B. als weichmagnetische Scheibe, einen senkrechten Abstand von ca. 30% der lateralen Ausdehnung des Sensors haben. Die Abschirmung selbst müsste bei einer lateralen Ausdehnung des Umdrehungszählers von 2 mm mindestens 4 mm laterale Ausdehnung und eine Dicke von 0, 5 mm aufweisen, um das B- Feld im Bereich des Umdrehungszählers anforderungsgemäß zu garantieren. Da der Winkelsensor nicht von der Abschirmung erfasst werden darf, um seine hohe Messgenauigkeit zu erreichen, müsste er zum Umdrehungszähler einen Mindestabstand von ca. 6 mm haben, was eine lateral enge Anordnung beider Sensoren bzw. eine Integration von Winkelsensor, Umdrehungszähler und der Auswerteelektronik auf einem Chip und in einem gemeinsamen Gehäuse üblicher Bauart unmöglich macht. Zugleich müsste der Permanentmagnet lateral vergrößert ausgeführt sein, damit beide Sensoren im homogenen Bereich des B- Feldes liegen. Große Permanentmagnete verursachen jedoch einen merklichen Kostenanteil des gesamten Sensorsystems. Wenn es gelingt, den Winkelsensor und den Umdrehungssensor eng beieinander zu positionieren, können kleinere Permanentmagnete verwendet und damit Kosten gespart werden. Könnte man darüber hinaus zumindest den Winkelsensor und den Umdrehungszähler in ein Gehäuse integrieren, würde dies den Gesamtpreis gegenüber der Verwendung von Sensoren in separaten Gehäusen senken. Außerdem würden Montagekosten gespart.

Ein Umdrehungszähler, wie er in DE 10 2008 063 226 A1 beschrieben ist, enthält einen magnetischen Leiter, in dem sich magnetische Domänenwände bewegen. Dieser kann Teil eines GMR-Stacks (Giant magneto resistance) oder eines TMR-Stacks (Tunneling magneto resistance) sein und in einer spiralartigen Form hergestellt werden. Das magnetische Fenster einer derartigen Spirale kann z.B. durch die Breite der weichmagnetischen Struktur im Stack eingestellt werden. Schmalere Breiten ergeben höhere Werte für den unteren und oberen Wert des magnetischen Fensters. Für einen Umdrehungszähler, der bei 100 mT arbeiten soll, müsste man die Strukturbreiten auf ¼ der bisher verwendeten Strukturbreite von -350 nm reduzieren. Es ist jedoch schwierig, Strukturen mit Strukturbreiten unter 100 nm herzustellen anstelle der bisher typischen 350 nm. Wenn man lithographische Prozesse für die Strukturierung verwendet, besteht die große Gefahr, dass sich durch die unvermeidbare Rauigkeit der magnetischen Leiter die Ausbeute der Bauelemente merklich verschlechtert. Aus der WO2015/062573 A1 ist ein weiterer Umdrehungszähler bekannt.

Der Erfindung liegt die Aufgabe zugrunde, ein magnetisches System zur Zählung von Umdrehungen mit erhöhter magnetischer Störfeldfestigkeit anzugeben, das in einem Magnetfeldbereich (B-Feldbereich) eingesetzt werden kann, der deutlich oberhalb des nach dem Stand der Technik üblicher Weise verwendeten liegt. Außerdem soll die Breite des magnetischen Fensters ΔB, also die Differenz zwischen unterem und oberem B-Wert, der im Einsatz zugelassen werden kann, möglichst groß sein.

Die Aufgabe wird durch die kennzeichnenden Merkmale des Anspruchs 1 gelöst. Das Wesen der Erfindung besteht dabei darin, dass dem Umdrehungszähler eine sich in ihrer magnetischen Wirkung selbsttätig anpassende magnetische Dämpfungsstruktur, ausgenommen einer aus einem homogenen weichmagnetischen Material bestehenden, zugeordnet ist, die bei einem äußeren Magnetfeld von Null kein oder nur verschwindet geringes eigenes Magnetfeld aufweist. Vorteilhafte Ausgestaltungen sind Gegenstand der nachgeordneten Ansprüche.

Zur detaillierten Erläuterung der Erfindung sollen nachfolgende Ausführungsbeispiele dienen. Es zeigen:
- Fig. 1: eine nach dem Stand der Technik übliche Anordnung eines Winkelsensors und eines Umdrehungszählers;
- Fig. 2: eine grundsätzliche Ausführung gemäß vorliegender Erfindung;
- Fig. 3: eine beispielhafte Integration eines Winkelsensors, eines Umdrehungszählers und gegebenenfalls einer Auswerteelektronik in einem Chip;
- Fig. 4: eine erste Ausführungsmöglichkeit einer erfindungsgemäß eingesetzten magnetischen Dämpfungsstruktur;
- Fig. 5: eine zweite Ausführungsmöglichkeit einer erfindungsgemäß eingesetzten magnetischen Dämpfungsstruktur;
- Fig. 6: eine dritte Ausführungsmöglichkeit einer erfindungsgemäß eingesetzten magnetischen Dämpfungsstruktur;
- Fig. 7: eine beispielhafte Darstellung der Wirkung einer erfindungsgemäßen magnetischen Dämpfungsstruktur;
- Fig. 8: beispielhaft zwei unterschiedliche geometrische Ausbildungen der magnetischen Dämpfungsstruktur in Draufsicht und im Querschnitt;
- Fig. 9: eine beispielhafte Anordnung der Dämpfungsstruktur oberhalb des magnetisch sensitiven Teils des Umdrehungszählers;
- Fig. 10: eine beispielhafte Anordnung der Dämpfungsstruktur unterhalb des magnetisch sensitiven Teils des Umdrehungszählers;
- Fig. 11: eine beispielhafte Anordnung des Winkelsensor und des Umdrehungszählers auf einer Platine gemeinsam mit der Auswerteelektronik und
- Fig. 12: eine beispielhafte Anordnung des Winkelsensors und Umdrehungszählers in einem gemeinsamen Gehäuse.

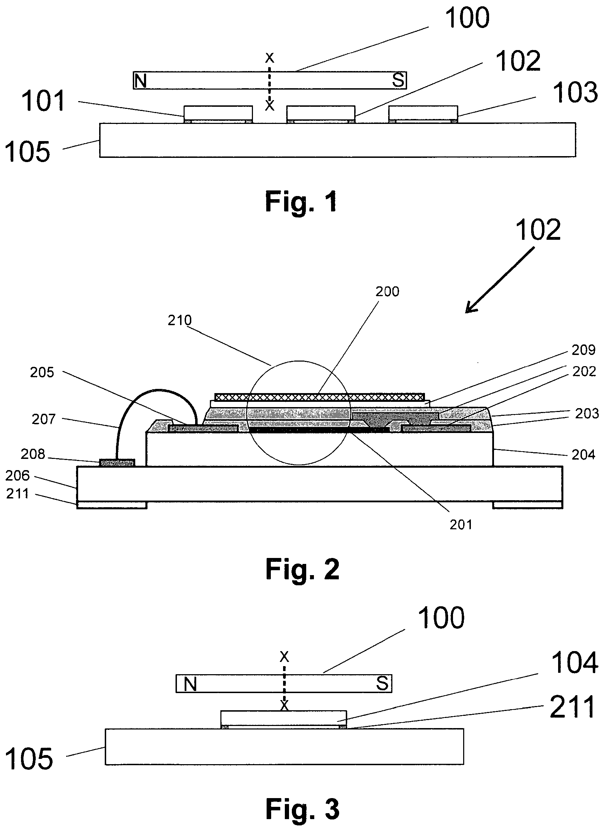

Figur 1 zeigt zunächst eine prinzipielle Ausführung eines magnetischen Umdrehungszählers, wie sie nach dem Stand der Technik üblich ist und die auch grundsätzlich in vorliegender Erfindung beibehalten werden soll.

Auf einer Leiterplatte 105 sind ein Winkelsensor 101, ein Umdrehungszähler 102 und ein Bauelement mit Auswerteelektronik 103 beispielhaft angeordnet. Der Winkelsensor 101 und der Umdrehungszähler 102 werden im Beispiel von einem, beide Bauelemente 101 und 102 gleichmäßig erfassenden und um seine Achse X-X rotierbaren Permanentmagneten 100 überdeckt und von dessen magnetischen B-Feld in gleicher Weise erfasst.

Figur 2 zeigt eine grundsätzliche Ausführung gemäß vorliegender Erfindung. Hier ist dem Umdrehungszähler 102 intern integriert eine smarte, das heißt eine sich in ihrer magnetischen Wirkung selbsttätig anpassende magnetische Dämpfungsstruktur 200 zugeordnet. Die Lage der Dämpfungsstruktur 200 innerhalb des Umdrehungszählers 102 zeigt Fig. 2 in einem ersten Beispiel. Auch dieser erfindungsgemäße Umdrehungszähler 102 kann dann auf einer Leiterplatte 105 direkt neben den Winkelsensor 101 angebracht sein. Beide Sensoren werden dann, genauso, wie in Fig. 1 dargestellt, vom Magnetfeld, das vom Permanentmagneten 100 erzeugt wird, erfasst.

Ein Chip mit Auswerteelektronik 103 kann ebenfalls auf der Platine 105 angeordnet sein. Aus Kostengründen sehr vorteilhaft ist die Integration des Winkelsensors und Umdrehungszählers und gegebenenfalls der Auswerteelektronik in einem alle genannten Bauelemente gemeinsam beinhaltenden Chip 104, wie es in Fig. 3 schematisch dargestellt ist.

Die Wirkung der magnetischen smarten Dämpfungsstruktur 200 ermöglicht es, das magnetische Fenster deutlich zu vergrößern, z.B. von bislang üblichen 15 mT- 30 mT (ohne Verwendung der erfindungsgemäßen Dämpfungsstruktur 200) auf 60 mT- 120 mT bei Verwendung der Dämpfungsstruktur 200. Die Breite des magnetischen Fensters erhöht sich in diesem Beispiel dabei von 15 mT auf 60 mT, also um den Faktor 4. Das maximal zulässige magnetische Störfeld kann, wenn man den Sensor bei 90 mT betreibt, 30 mT betragen und damit rund um den Faktor 6 vergrößert sein. Dies vereinfacht den Einsatz des Umdrehungszählers deutlich, da eine sonst nach dem Stand der Technik übliche separate, hier nicht dargestellte magnetische Abschirmung einfacher oder sogar völlig überflüssig wird. Dies erspart Kosten und eröffnet dem magnetischen Umdrehungszähler neue Einsatzfelder. Ein wesentlicher Vorteil dieser erfindungsgemäßen Lösung besteht darin, dass durch die neuartige Dämpfungsstruktur 200 eine Integration des Winkelsensors 101 mit dem Umdrehungszähler 102 und gegebenenfalls auch noch der Auswerteelektronik 103 in einem Chip 104 möglich wird. Eine derartige Integrationsmöglichkeit erlaubt es, einen in seinen geometrischen Abmessungen verkleinerten Permanentmagneten 100 zu verwenden. Dies und die Verringerung des Montageaufwandes führen zu einer preiswerteren Lösung als bislang nach dem Stand der Technik möglich.

Im Folgenden soll die spezielle Ausbildung der erfindungsgemäßen magnetischen Dämpfungsstruktur 200 anhand mehrerer spezieller Beispiele erläutert werden. Erfindungsgemäß sollen für den Einsatz in der Dämpfungsstruktur 200 magnetische Materialien zum Einsatz gelangen, die aufgrund ihrer intrinsischen Eigenschaften bei einem äußeren Magnetfeld von B=0 kein oder nur ein sehr kleines eigenes B-Feld erzeugen und bei deren Ummagnetisierung keine oder nur geringe magnetische Verluste auftreten.

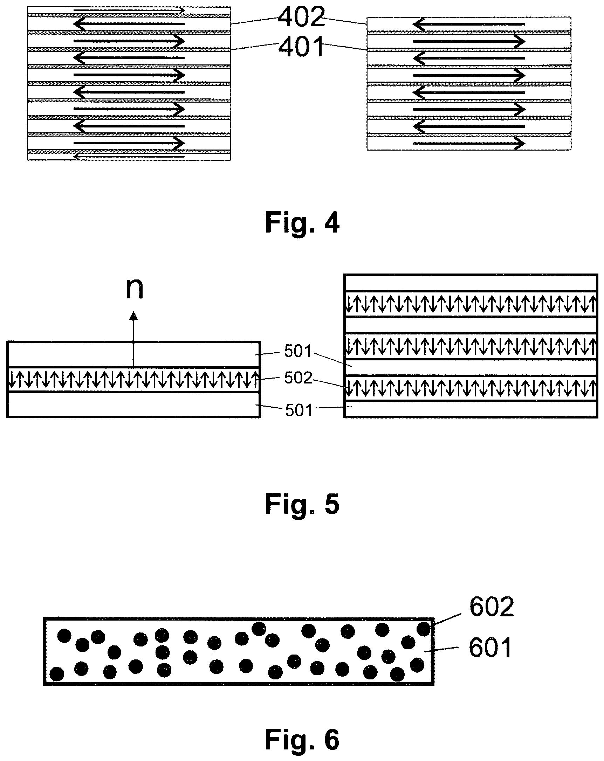

Dies kann, wie in Fig. 4 für ein erstes Beispiel und zwei danach möglichen Anordnungen gezeigt, erreicht werden, wenn die magnetische Dämpfungsstruktur aus übereinander gestapelten, in der Ebene magnetisierten und dabei jeweils antiparallel ausgerichteten Teilschichten 402 besteht, deren jeweilige Dicke so gewählt ist, dass sie sich gegenseitig magnetisch kompensieren. Eine antiparallele Ausrichtung der Schichten 402 entsteht, wenn man dünne ferromagnetische Schichten 402 durch ultradünne Schichten 401 von z.B. Kupfer oder Ruthenium trennt. Eine antiparallele Orientierung tritt z.B. auf, wenn die Dicke des Ru zwischen 0,8 nm und 1 nm liegt oder die des Cu um 1 nm oder um 2 nm beträgt. Das B-Feld Bₛₐₜ, das zu einer vollständigen parallelen Ausrichtung der Magnetisierungen der Bereiche 402 benötigt wird, hängt von der Dicke und Art der nichtmagnetischen Zwischenschicht 401 und vom Material der ferromagnetischen Schicht 402 und deren Dicke ab. Für eine 3 nm dicke Co₉₀Fe₁₀- Schichten und 0,8 nm Ru benötigt man ein Bₛₐₜ von -900 mT. Erhöht man die Dicke der Einzellage auf den 10-fachen Wert, also 30 nm, reduziert sich der Wert von Bₛₐₜ auf 1/10, also ~90 mT. Durch die Wahl der Dicke der einzelnen ferromagnetischen Schichten 402 lässt sich damit der gewünschte Wert von Bₛₐₜ einfach einstellen. Das Gesamt-B-Feld, das von einer derartigen Struktur am Ort des weichmagnetischen Leiters als Bestandteil des GMR- oder TMR-Stapels zur Führung magnetischer Domänen (siehe 201 in Fig. 2) erzeugt werden kann, hängt von der Gesamtdicke sowie deren lateralen Ausdehnung ab. Deshalb werden erfindungsgemäß bevorzugt Stapel derartiger Anordnungen, wie sie beispielhaft in Fig. 4 gezeigt sind, verwendet. Ist die Dicke der magnetischen Lagen 402 im gesamten Schichtstapel konstant, so erhält man die in Fig. 4 rechts dargestellte Anordnung.

Eine andere mögliche Anordnung im Rahmen dieses Ausführungsbeispiels, ist die in Fig. 4 links gezeigte, bei der die obere und untere ferromagnetische Schicht 402 nur die halbe Dicke der anderen ferromagnetischen Schichten aufweisen. Bei beiden Konfigurationen nach Fig. 4 ist bei B=0 und damit in kompletter Antiparallelstellung aller einzelnem Magnetisierungen der Schichten 402 das nach außen wirkende B-Feld diese Schichten gleich Null.

Eine weitere erfindungsgemäße Ausbildung einer magnetischen Dämpfungsstruktur 200 ist in Fig. 5 dargestellt. Im Beispiel ist links ein 3-Lagen- Stapel dargestellt, der aus einer ferromagnetischen Schicht 502, die von zwei nichtferromagnetischen Schichten 501 begrenzt ist, besteht. Besteht das Material der Schicht 501 z.B. aus Pt, Pd, Ta oder MgO, so wird eine senkrechte Magnetisierung der Schicht 502 energetisch bevorzugt. Aus Gründen der magnetischen Streufeldenergie richten sich benachbarte Bereiche dabei antiparallel in Richtung der Normalen n der Schichtebene aus. Damit entsteht bei einem äußeren magnetischen Feld von B=0 wieder eine Schichtstruktur, die kein eigenes B-Feld erzeugt. Für eine 1,5 nm dicke Fe₆₀Co₂₀B₂₀-Schicht, die in MgO eingehüllt ist, liegt das Sättigungsfeld bei der Einwirkung eines magnetischen Feldes in der Schichtebene bei Werten von bis zu 500 mT. Das B-Feld, das eine in der Ebene ausgerichtete 1,5 nm dicke Fe₆₀Co₂₀B₂₀-Schicht erzeugt, ist für die Anwendung meist zu klein. Deshalb müssen viele Magnetschichten 502, die jeweils durch nichtferromagnetische Schichten 501 getrennt sind, übereinander angeordnet werden, wie es beispielhaft in Fig. 5 rechts dargestellt ist.

Eine dritte erfindungsgemäße Ausführungsmöglichkeit einer magnetischen Dämpfungsstruktur 200 zeigt Figur 6. Hier ist eine Ansammlung aus kleinen superparamagnetischen Teilchen 602, die jeder für sich ein superparamagnetisches Moment aufweisen und ungeordnet ausgerichtet sind und in eine nichtmagnetische Matrix 601 eingebettet sind, schematisch dargestellt. Eine solche Schichtstruktur weist bei einem äußeren Magnetfeld von B=0 kein magnetisches Nettomoment auf. Als Teilchen 602 können z.B. Magnetitteilchen mit einem Durchmesser von 10 nm bis 20 nm verwendet werden. Mit Anlegen eines magnetischen B-Feldes in Schichtebene nimmt die Nettomagnetisierung in erster Nähe linear mit dem B-Feld zu und erreicht bei Bₛₐₜ wieder den Zustand, bei dem alle Teilchen die gleiche magnetische Ausrichtung in der Ebene aufweisen. Typische Sättigungsfelder einer derartigen Struktur bei Raumtemperatur sind 250 mT.

Den erfindungsgemäßen Konfigurationen aus magnetisch antiparallel oder magnetisch ungeordnet ausgerichteten Teilbereichen ist es also gemein, dass sie bei einem äußeren Magnetfeld von B=0 kein oder nur ein verschwindend kleines eigenes B-Feld erzeugen. Um alle magnetischen Teilbereiche einer lateral ausgedehnten Struktur, wie für die magnetische Dämpfungsstruktur 200 vorgesehen, in eine Richtung, zum Beispiel in der Ebene, zu magnetisieren wird ein Sättigungsmagnetfeld Bₛₐₜ benötigt.

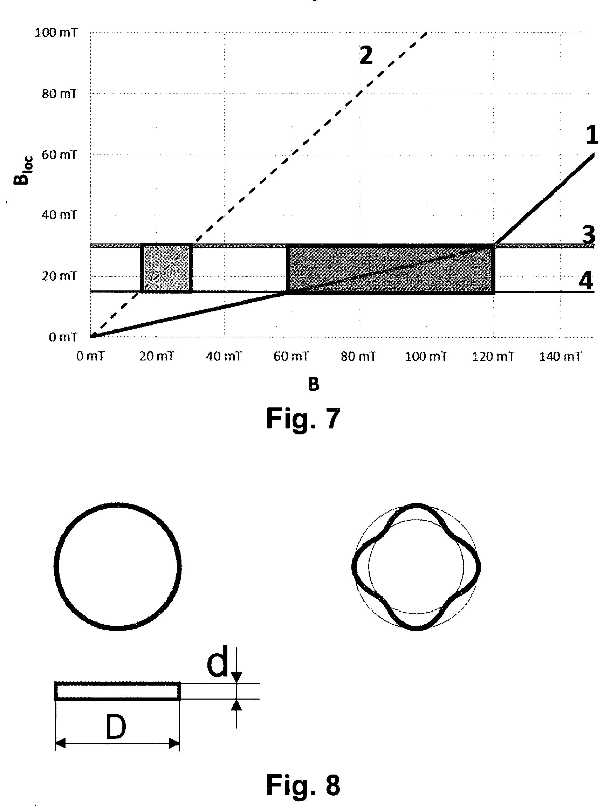

Bringt man vorstehend beschriebene Dämpfungsstrukturen in eine definierte geometrische Form, wie z.B. eine Scheibe der Dicke d und des Durchmessers D (vgl. Fig. 8), erzeugt diese Scheibe bei Anlegen eines Magnetfeldes ein magnetisches Streufeld und besitzt eine Streufeldenergie. Diese Streufeldenergie hat wiederum einen Einfluss auf die Magnetisierung und lässt sich mit Hilfe der magnetischen Formanisotropie (Shape anisotropy) beschreiben. Um diese Streufeldenergie zu überwinden ist ein Feld B^{SH}ₛₐₜ zur kompletten Ausrichtung in Richtung des Magnetfeldes nötigt. Die Sättigungsfeldstärke B^{SH}ₛₐₜ wird bestimmt durch das Verhältnis der Lateralausdehnung der Scheibe zu der Gesamtdicke der magnetischen Schicht(en) und dem Wert der Sättigungsmagnetisierung des ferromagnetischen Materials.

Besteht die magnetische Schicht aus einem Schichtstapel, wie er oben in einer der vorgenannten Möglichkeiten beschrieben ist, überlagern sich die beiden oben beschriebenen Effekte additiv. Das bedeutet, dass man ein größeres B-Feld Bᵣₑₛ in der Ebene anlegen muss, um alle magnetischen Bereiche (402 oder 502 oder 602) homogen in der Ebene auszurichten. Das Feld, das man dazu benötigt, ergibt sich aus der Addition der Einzelwerte für B^{SH}ₛₐₜ sowie für Bₛₐₜ nach der Gleichung: B^{res}ₛₐₜ = B^{SH}ₛₐₜ + Bₛₐₜ.

Nutzt man für die erfindungsgemäße magnetische Dämpfungsstruktur 200 eine kreisförmige Scheibe der Dicke von z.B. 20 m und einem Durchmesser von 1000 µm, bestehend aus einem Schichtstapel von 15 nm CoFe/0.8 nmRu/ [30 nm CoFe/0.8 nm Ru]₄₀ / 15 nm CoFe, so beträgt das B^{SH}ₛₐₜ = 35mT und das Bₛₐₜ= 90 mT. Damit beträgt das B^{res}ₛₐₜ als Summe von B^{SH}ₛₐₜ und Bₛₐₜ 125 mT.

Im Folgenden soll die Wirkung einer als Scheibe ausgebildeten smarten magnetischen Dämpfungsstruktur 200, die einem homogenen B-Feld ausgesetzt wird, anhand von Figur 7 beschrieben werden. Auf der Y-Achse sind mit waagerechten Linien die Werte für Bₘᵢₙ und Bₘₐₓ eines Umdrehungszählers 102 eingezeichnet. Bringt man diese Scheibe 200 so in ein äußeres Magnetfeld, dass das B-Feld parallel zur Scheibenoberfläche ausgerichtet ist, so ist in großer Entfernung von der Scheibe das B-Feld ungeändert (gestrichelte Linie in Fig. 7, markiert mit "2"). Direkt ober- oder unterhalb der Scheibe in Scheibenmitte erhält man ein B-Feld wie mit der dicken schwarzen Linie, markiert mit "1", dargestellt. Solange die Scheibe 200 magnetisch nicht gesättigt ist, also für B < B^{res}ₛₐₜ, erhöht sich das B-Feld an dieser Stelle linear, aber viel langsamer als das von außen einwirkende B-Feld. Deshalb schneidet die dicke Linie "1" die beiden Linien für Bₘᵢₙ "4" und Bₘₐₓ "3" des Umdrehungszählers erst bei viel größeren B-Werten. Das hat zur Folge, dass das magnetische Fenster von ursprünglich 20 mT bis 40 mT auf ein magnetisches B-Fenster von 60 mT bis 120 mT vergrößert ist. Das bedeutet, für die Anwendung für den Umdrehungssensor steht ein dreimal breiteres Fenster zur Verfügung. Damit verbessert sich auch die Stabilität gegen Fremd- oder Störfelder, was ebenfalls große Vorteile für den Anwendungsfall bringt.

Für den hier beschriebenen Fall der kreisförmigen Ausbildung der Dämpfungsstruktur 200 (entsprechend Figur 8 links) ist das magnetische Verhalten der Scheibe in allen Richtungen in der Ebene gleich, das heißt, das ober- und unterhalb der Dämpfungsstruktur wirkende B-Feld ist betragsmäßig für alle Richtungen des B-Feldes in der Ebene identisch. Das ist für den spiralförmig aufgebauten Umdrehungszähler, wie er aus DE 10 2008 063 226 A1 bekannt ist, das erwünschte Verhalten.

Bei einer Verwendung von sogenannten Closed Loop-Strukturen, wie sie bspw. im Patent EP 3 066 421 B1 beschrieben sind, ist dies anders. Diese Geometrie verwendet eine Spirale, deren beiden Enden miteinander verbunden sind. Dadurch entstehen Kreuzungen der magnetischen Leitungen. An den Kreuzungen ist die Breite des magnetischen Leiters in Richtung der Diagonale der Kreuzung um rund 45% erhöht. Dies führt dazu, dass das magnetische Fenster in 0°-Richtung sich unterscheidet von dem magnetischen Fenster in 45°-Richtung. Derartige Unterschiede können kompensiert werden, wenn die Dämpfungsstruktur nicht mehr kreisförmig ist, sondern eine wie in Fig. 8 rechts dargestellte Form aufweist. Erfindungsgemäß wird deshalb für die Dämpfungsstruktur für einen Umdrehungszähler, der auf der Basis einer Closed Loop -Struktur (EP 3 066 421 B1) arbeitet, vorgeschlagen, die Dämpfungsstruktur nicht mehr kreisförmig auszubilden sondern wie in Fig. 8 rechts dargestellt, in ausgewählten Richtungen zu ändern. Auf diese Weise sind Unterschiede bezüglich des B-Feldes in unterschiedlichen Richtungen durch die Wahl der Geometrie der Dämpfungsscheiben einfach anpassbar, bei der die Lateralausdehnung in unterschiedlichen Richtungen verschieden ist. Ist die Scheibe in einer Richtung um 20% im Durchmesser vergrößert, so ist der Wert von B^{SH}ₛₐₜ in dieser Richtung um 20% reduziert. Als Beispiel sei auf die zweizählige Geometrie der smarten Dämpfungsscheibe in Fig. 8 rechts verwiesen. Links im Fig. 8 ist B^{SH}ₛₐₜ in alle Richtungen gleich, das magnetische Verhalten also isotrop. In der rechts dargestellten Geometrie in Fig. 8 ist das Sättigungsfeld B^{SH}ₛₐₜ in X- und Y-Richtung identisch, aber verschieden von den in +/- 45° vorliegenden Sättigungsfeld B^{SH}ₛₐₜ.

Die Anordnung der Dämpfungsstruktur 200 unmittelbar zum magnetisch sensitiven Teil 201 des Umdrehungszählers wird beispielhaft in den Figuren 2, 9 und 10 erläutert. Die Fig. 2 zeigt schematisch einen Querschnitt eines Umdrehungszählerchips. Das Siliziumsubstrat 204, auf dem sich der funktionelle Teil des Umdrehungszählers befindet, ist auf die Bodenplatte das Gehäuse 206 des Umdrehungszählers geklebt. Die elektrische Verbindung vom auf dem Si- Substrat 204 aufgebrachten Bondpadstrukturen 205 des Umdrehungszählers ist durch Bonddrähte 207 realisiert, die die auf dem Si-Substrat 204 befindlichen Bondpads 205 mit den Bondpads 208 des Gehäuses verbindet. Für das Einlöten des Chips auf eine Leiterplatte 105 (vgl. Fig. 3) werden die Lötkontakte 211 genutzt. Die auf das Si-Substrat aufgebrachten Strukturen beinhalten die funktionelle Struktur 201 des Umdrehungszählers, die Metallisierungsstrukturen 202 sowie die Bondpads 205. Diese Strukturen sind zumindest partiell mit einer Isolationsschicht 203 abgedeckt. Die erfindungsgemäße Dämpfungsschicht 200 ist nur in einem Teilbereich des Si-Substrates aufgebracht und bedeckt die für die Funktion des Umdrehungszählers relevante Struktur 201 komplett mit einem kleinen lateralen Überstand. Ihre laterale Gesamtausdehnung kann deshalb kleiner sein als die Fläche des Si-Substrates 204. Eine ebenfalls als Planarisierungsschicht wirkende Isolierungsschicht 209 kann sich unter der Dämpfungsschicht 200 befinden.

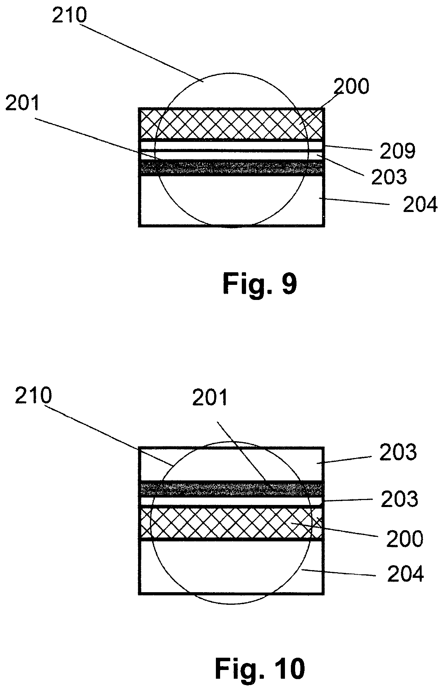

Die Lage der Dämpfungsstruktur 200 kann, wie in den Fig. 9 und 10 (Kreisausschnitt 210 aus Fig. 2) dargestellt, sowohl ober- als auch unterhalb der Struktur 201 angeordnet sein. Das hängt damit zusammen, dass das von der Dämpfungsstruktur 200 erzeugte B-Feld ober- und unterhalb der Dämpfungsstruktur 200 nahezu identisch ist, da der geometrische Abstand dieser beiden Positionen klein ist zum Abstand zum Permanentmagneten. Die Isolationsschichten sind, wie unten angegeben, i.a. nur wenige µm dick, die GMR- oder TMR-schicht nur ca. 70 nm und der Abstand 201 zu 100 immer in der Mindestgröße von 1 mm.

Ausgehend von Fig. 2 ist ersichtlich, dass die Dämpfungsschicht lateral ein Ausmaß einnimmt, das unterhalb des ohnehin für Bondpads erforderlichen Platzbedarfs liegt. Da die Dicke der Isolations- und Zwischenschichten 203 und 209 nur im Bereich weniger µm liegt, muss die Dämpfungsstruktur lateral die magnetisch sensitive Struktur 201 des Umdrehungszählers auch nur um wenige bis wenige zehn µm überragen, um Effekte, die nur an den Enden der Dämpfungsstruktur auftreten, in ihrem Einfluss hinreichend zu minimieren. Generell gilt für alle erfindungsgemäßen Ausführungsbeispiele, dass die Dämpfungsschicht 200 in lateraler Ausdehnung die weichmagnetischen GMR- oder TMR-Strukturen 201 des Umdrehungszählers 102 nicht mehr als 30% lateral überragt. Damit ist ersichtlich, dass die neue Bauform die bisherige Bauformen im Platzbedarf nicht übertrifft und nun sogar, wenn nicht Winkelsensor und Umdrehungszähler separat verkapselt werden, durch eine gemeinsame Verkapselung beider Sensoren diese sogar noch enger benachbart (Abstand < 200 µm) angeordnet werden können, da die Ausdehnung der Dämpfungsstruktur 200, wie in Fig. 2 dargestellt, merklich kleiner als der Umdrehungszähler 102 ist. Ohne eine gemeinsame Verkapselung kann ein Umdrehungszähler ebenfalls eng benachbart (Abstand < 200 µm) an einen Winkelsensor angeordnet werden, ohne die oben beschriebenen Vorteile zu verlieren. Daraus folgt, dass durch eine enge Benachbarung des Umdrehungszählers 102 zum Winkelsensor 101, ebenso wie bei einer gemeinsamen Verkapselung beider Teile in einem gemeinsamen Gehäuse, ein kleinerer Permanentmagnet 100 ermöglicht wird, was wiederum ein deutlich kleineres Gesamtsystem und reduzierte Kosten für den Permanentmagneten mit sich bringt.

Die Technologie der Herstellung der Dämpfungsschicht 200 ist für die in Fig. 4 und 5 dargestellten Systeme über einen Sputterprozess möglich und lässt sich damit im gleichen Produktionsprozess durchführen wie die Herstellung des Umdrehungszählers selbst.

Durch die vorgeschlagene Dämpfungsstruktur 200 lässt sich eine deutlich verbesserte Störfeldfestigkeit des magnetischen Umdrehungszählers erreichen, wodurch sich die Kosten insbesondere für anderenfalls erforderliche magnetische Abschirmungen beim Einsatz reduzieren lassen oder sogar ganz darauf verzichtet werden kann.

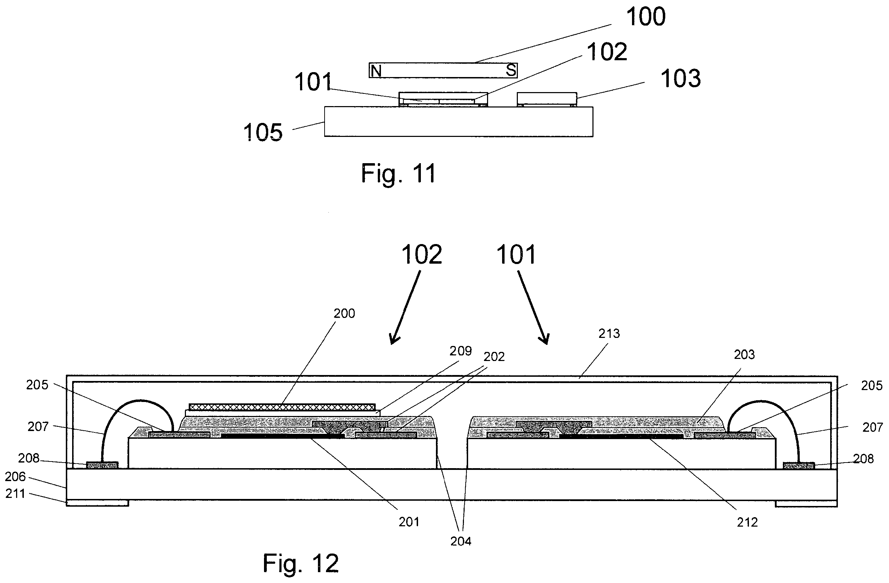

Zusätzlich, bedingt durch die begrenzte laterale Ausdehnung der Dämpfungsschicht, ermöglicht die vorgeschlagene Lösung die Integration des Winkelsensors und des Umdrehungszählers, wie in Fig. 11 und 12 dargestellt, und auch ggf. der Auswerteelektronik (wie in Fig. 3 dargestellt) in einer gemeinsamen, alle Bauelemente umfassenden gemeinsamen hermetisch abgedichteten Umhausung 213. Durch vorliegende Erfindung ist es ermöglicht, den Abstand von Winkelsensor 101 und Umdrehungszähler 102 in der Größenordnung von kleiner 500 µm festzulegen. Für die Umhausung 213 kann ein kommerziell verfügbares Chipgehäuse verwendet werden. Dies reduziert den konstruktiven Aufwand für das Gesamtsystem, erlaubt kompaktere Lösungen und spart somit erhebliche Kosten. Auch können durch die Erfindung kleinere Permanentmagneten 100 zum Einsatz gelangen, was die Kosten für das Gesamtsystem weiter senkt. Ebenso verschafft das durch vorliegende Erfindung verbreiterte magnetische Fenster des Umdrehungszählers 102 geringere Toleranzanforderungen an die Permanentmagneten 100.

### Bezugszeichenliste

- 100: Permanentmagnet
- 101: Winkelsensor
- 102: Umdrehungszähler
- 103: Auswerteelektronik
- 104: Chip mit Winkelsensor und Umdrehungszähler
- 105: Leiterplatte
- 200: Dämpfungsstruktur
- 201: Weichmagnetischer Leiter als Bestandteil des GMR- oder TMR-Stapels zur Führung magnetischer Domänen
- 202: Metallisierung
- 203: Isolationszwischenschicht
- 204: Siliziumsubstrat
- 205: Kontakt mit Kontaktöffnung
- 206: Chipunterteil (Gehäuse)
- 207: Bonddraht
- 208: Kontaktpad im Chipgehäuse
- 209: Planarisierungsschicht
- 210: Markierter Kreis (für spätere Abbildungen in Fig.9 und 10)
- 211: SMD-Bondpad
- 212: Weichmagnetischer Leiter als Bestandteil des GMR- oder TMR-Winkelsensors
- 213: Umhausung
- 401: nichtferromagnetische dünne Schicht
- 402: ferromagnetische dünne Schicht
- 501: Schicht, die eine magnetische Senkrechtanisotropie der Schicht 502 erzeugt
- 502: ferromagnetische dünne Schicht
- 601: nichtmagnetische Matrix
- 602: (superpara-)magnetischen Teilchen

## Patentansprüche

1. Magnetisches System zur Zählung von Umdrehungen mit erhöhter magnetischer Störfeldfestigkeit, beinhaltend einen Winkelsensor (101) zur Bestimmung der Feldrichtung eines ihn und einen Umdrehungszähler (102) gemeinsam erfassenden Magnetfeldes eines Permanentmagneten (100), wobei der Umdrehungszähler durch einem GMR- oder TMR-Umdrehungszähler bekannter Bauart gebildet ist und beide Sensoren (101, 102) in einer gemeinsamen Umhausung (213) und/oder auf einer gemeinsamen Platine (105) nebeneinander angeordnet sind, **dadurch gekennzeichnet, dass** dem Umdrehungszähler (102) eine sich in ihrer magnetischen Wirkung selbsttätig anpassende magnetische Dämpfungsstruktur (200), bestehend aus einer magnetisch antiparallelen Konfiguration oder aus magnetisch ungeordnet ausgerichteten Teilbereichen, ausgenommen einer aus einem homogenen weichmagnetischen Material bestehenden, zugeordnet ist, die bei einem äußeren Magnetfeld von Null kein oder nur ein verschwindend geringes eigenes Magnetfeld aufweist.

2. Magnetisches System nach Anspruch 1, **dadurch gekennzeichnet, dass** die Dämpfungsschicht (200) in lateraler Ausdehnung die weichmagnetischen GMR- oder TMR-Strukturen (201) des Umdrehungszählers (102) nicht mehr als 30% lateral überragt.

3. Magnetisches System nach Anspruch 1 und 2, **dadurch gekennzeichnet, dass** die Dämpfungsschicht (200) aus einem Schichtstapel, bestehend aus übereinander gestapelten, in der Ebene magnetisierten und dabei jeweils antiparallel ausgerichteten ferromagnetischen Teilschichten (402) besteht, deren jeweilige Dicke so gewählt ist, dass sie sich gegenseitig magnetisch kompensieren, wobei die Teilschichten (402) durch nichtferromagnetische Dünnschichten (401) getrennt sind, gebildet ist.

4. Magnetisches System nach Anspruch 1 und 2, **dadurch gekennzeichnet, dass** die Dämpfungsschicht (200) aus einem Schichtstapel, bestehend aus zumindest einer ferromagnetischen Schicht (502), die von zwei nichtferromagnetischen Schichten (501) beidseitig erfasst ist, wobei die Schicht (502) eine senkrechte Magnetisierung parallel zur Normalen (n) der Schicht (502) aufweist und benachbarte Magnetfeldbereiche dabei eine antiparallele Richtung einnehmen, gebildet ist.

5. Magnetisches System nach Anspruch 1 und 2, **dadurch gekennzeichnet, dass** die Dämpfungsschicht (200) aus einem Schichtsystem, bestehend aus einer Ansammlung aus kleinen superparamagnetischen Teilchen (602), die jedes für sich ein superparamagnetisches Moment aufweisen und ungeordnet ausgerichtet sind und in eine nichtmagnetische Matrix (601) eingebettet sind, gebildet ist.

6. Magnetisches System nach einem der vorstehenden Ansprüche, **dadurch gekennzeichnet, dass** die Dämpfungsschicht (200) ober- oder unterhalb der sensitiven Schicht (201) des Umdrehungszählers (102) vorgesehen ist.

7. Magnetisches System nach einem der vorstehenden Ansprüche, **dadurch gekennzeichnet, dass** je nach verwendetem Typ des Umdrehungszählers (102) der Dämpfungsschicht (200) eine in Draufsicht von der Kreisform auch abweichende Geometrie zur Berücksichtigung des Effekts der Formanisotropie gegeben ist.

8. Magnetisches System nach Anspruch 1, **dadurch gekennzeichnet, dass** der Abstand von Winkelsensor (101) und Umdrehungszähler (102) in der Größenordnung von kleiner 500 µm festgelegt ist und zumindest diese beiden Bauelemente von einer gemeinsamen Umhausung (213) hermetisch abgedichtet umfasst sind.

9. Magnetisches System nach Anspruch 1, **dadurch gekennzeichnet, dass** der Abstand von Winkelsensor (101) und Umdrehungszähler (102) in der Größenordnung von kleiner 500 µm festgelegt ist und zumindest diese beiden Bauelemente gemeinsam mit einer Auswerteelektronik (103) von einer gemeinsamen Umhausung (213) hermetisch abgedichtet umfasst sind.

## Claims

1. A magnetic system for counting revolutions having increased magnetic interference field immunity, comprising an angle sensor (101) for determining the field direction of a magnetic field of a permanent magnet (100) which jointly captures the angle sensor and a revolution counter (102), the revolution counter being formed by a GMR or TMR revolution counter having a known design, and the two sensors (101, 102) being disposed next to one another in a shared enclosure (213) and/or on a shared printed circuit board (105), **characterized in that** a magnetic damping structure (200) consisting of a magnetically anti-parallel configuration or of magnetically disordered subregions, except one made of a homogeneous soft magnetic material, and automatically adapting its magnetic action is assigned to the revolution counter (102), the damping structure having no, or only a negligibly small, magnetic field of its own at an external magnetic field of zero.

2. The magnetic system according to claim 1, **characterized in that** the damping layer (200), in the lateral extension, does not laterally protrude beyond the soft magnetic GMR or TMR structures (201) of the revolution counter (102) by more than 30%.

3. The magnetic system according to claims 1 and 2, **characterized in that** the damping layer (200) consists of a layer stack composed of ferromagnetic sub-layers (402), which are stacked on top of one another, magnetized in the plane and in each case oriented anti-parallel, the respective thickness of which being selected such that these compensate for one another magnetically, the sub-layers (402) being separated by non-ferromagnetic thin films (401).

4. The magnetic system according to claims 1 and 2, **characterized in that** the damping layer (200) is formed of a layer stack, comprising at least one ferromagnetic layer (502), which is captured on both sides by two non-ferromagnetic layers (501), the layer (502) having a perpendicular magnetization parallel to the normal (n) of the layer (502) and neighbouring magnetic field regions taking on an anti-parallel direction.

5. The magnetic system according to claims 1 and 2, **characterized in that** the damping layer (200) is formed of a layer system, comprising an accumulation of small superparamagnetic particles (602), each having a superparamagnetic moment and being oriented in a disordered manner and embedded in a non-magnetic matrix (601).

6. The magnetic system according to any of the preceding claims, **characterized in that** the damping layer (200) is provided above or below the sensitive layer (201) of the revolution counter (102).

7. The magnetic system according to any of the preceding claims, **characterized in that**, depending on the type of revolution counter (102) used, a geometry deviating from a circular shape, in a top view, is given to the damping layer (200) so as to take the effect of shape anisotropy into consideration.

8. The magnetic system according to claim 1, **characterized in that** the distance between the angle sensor (101) and the revolution counter (102) is established at an order of magnitude of less than 500 µm, and at least these two components are enclosed in a hermetically sealed manner by a shared enclosure (213).

9. The magnetic system according to claim 1, **characterized in that** the distance between the angle sensor (101) and the revolution counter (102) is established at an order of magnitude of less than 500 µm, and at least these two components, together with evaluation electronics (103), are enclosed in a hermetically sealed manner by a shared enclosure (213).

## Revendications

1. Système magnétique avec une immunité aux champs magnétiques augmentée, comportant un capteur d'angle (101) afin de déterminer la direction du champ d'un champ magnétique d'un aimant permanent (100) captant en même temps le capteur d'angle et un compte-tours (102), le compte-tours étant constitué d'un compte-tours GMR ou TMR d'un type de construction connu et les deux capteurs (101, 102) étant juxtaposés dans un carter (213) commun et/ou sur une platine (105) commune, **caractérisé en ce qu'**une structure d'amortissement magnétique (200) consistant en une configuration magnétiquement antiparallèle ou en sous-zones magnétiquement désordonnées, sauf une constituée d'un matériau magnétique doux homogène, et auto-adaptable dans son effet magnétique est associée au compte-tours (102) et ne présentant seulement qu'un propre champ magnétique extrêmement infime en présence d'un champ magnétique externe de zéro.

2. Système magnétique selon la revendication 1, **caractérisé en ce que** la couche d'amortissement (200) en étendue latérale ne dépasse pas les structures GMR ou TMR (201) du compte-tours (102) de plus de 30 %.

3. Système magnétique selon la revendication 1 ou 2, **caractérisé en ce que** la couche d'amortissement (200) est formée d'un empilement de couches consistant en sous-couches (402) ferromagnétiques empilées les unes sur les autres, magnétisées dans le plan et chacune placée selon une orientation antiparallèle, dont l'épaisseur est choisie de façon à ce qu'elles fournissent une compensation magnétique mutuelle, les sous-couches (402) étant séparées par des couches minces (401) non-ferromagnétiques.

4. Système magnétique selon les revendications 1 et 2, **caractérisé en ce que** la couche d'amortissement (200) est formée d'un empilement de couches consistant en au moins une couche ferromagnétique (502) couverte sur les deux côtés par deux couches non-ferromagnétiques (501), la couche (502) présentant une magnétisation perpendiculaire parallèle à la normale (n) de la couche (502) et les zones du champ magnétique adjacentes prenant une direction antiparallèle.

5. Système magnétique selon les revendications 1 et 2, **caractérisé en ce que** la couche d'amortissement (200) est formée d'un système de couches consistant en une accumulation de petites particules (602) superparamagnétiques, chacune dotée d'un moment superparamagnétique et étant orientée d'une manière désordonnée et incorporée dans une matrice (601) non-magnétique.

6. Système magnétique selon l'une des revendications précédentes, **caractérisé en ce que** la couche d'amortissement (200) est prévue au-dessus ou au-dessous la couche sensible (201) du compte-tours (102).

7. Système magnétique selon l'une des revendications précédentes, **caractérisé en ce que**, selon le type de compte-tours (102) utilisé, dans une vue de dessus, une géométrie différente de la forme circulaire est donnée à la couche d'amortissement (200) afin de tenir compte de l'effet de l'anisotropie de forme.

8. Système magnétique selon la revendication 1, **caractérisé en ce que** la distance entre le capteur d'angle (101) et le compte-tours (102) est établie à une échelle de moins de 500 µm et que ces deux composants au moins sont confinés dans un carter (213) commun de manière hermétique.

9. Système magnétique selon la revendication 1, **caractérisé en ce que** la distance entre le capteur d'angle (101) et le compte-tours (102) est établie à une échelle de moins de 500 µm et que ces deux composants au moins, ensemble avec une électronique d'évaluation (103), sont confinés dans un carter (213) commun de manière hermétique.
